# FASCICULE DE BREVET EUROPEEN

(11) **EP 2 359 155 B1**
(45) Date de publication et mention de la délivrance du brevet: **19.09.2012**
(21) Numéro de dépôt: 09801478.0
(22) Date de dépôt: 02.12.2009
(51) Int. Cl.: G01R 31/28

(54) **DISPOSITIF DE TEST DE CIRCUIT INTEGRE ET PROCEDE DE MISE EN OEUVRE**
EINRICHTUNG ZUM PRÜFEN EINER INTEGRIERTEN SCHALTUNG UND VERFAHREN ZU IHRER IMPLEMENTIERUNG
DEVICE FOR TESTING AN INTEGRATED CIRCUIT AND METHOD FOR IMPLEMENTING SAME

(30) Priorité: 17.12.2008 FR 0858737
(43) Date de publication de la demande: 24.08.2011
(73) Titulaire: European Aeronautic Defence And Space Company EADS, 75016 Paris (FR)
(72) Inventeur: MILLER, Florent, F-92300 Levallois (FR); WEULERSSE, Cécile, F-78000 Versailles (FR); BOUGEROL, Antonin, F-92150 Suresnes (FR); CARRIERE, Thierry, F-78510 Triel sur Seine (FR); HEINS, Patrick, F-81140 Castelnau de Montmiral (FR); HAZO, Samuel, F-31500 Toulouse (FR)
(74) Mandataire: Marconnet, Sébastien
(86) Numéro de dépôt international: PCT/FR2009/052377
(87) Numéro de publication internationale: WO 2010/076448

(56) Documents cités:
- WO-A-2007/119030
- JP-A- 2008 173 298
- US-A- 5 850 145
- US-A1- 2006 256 925
- DUZELLIER S ET AL: "Heavy Ton / Proton Test Results On High Integrated Memories" RADIATION EFFECTS DATA WORKSHOP, 1993., IEEE SNOWBIRD, UT, USA 21 JULY 1993, NEW YORK, NY, USA,IEEE, 1 janvier 1993 (1993-01-01), pages 36-42, XP010122967 ISBN: 978-0-7803-1906-6
- SAKAE TAKEJI ET AL: "Conformal irradiation by proton beam scanning and multilayer energy filter" REVIEW OF SCIENTIFIC INSTRUMENTS, AIP, MELVILLE, NY, US, vol. 74, no. 3, 1 mars 2003 (2003-03-01), pages 1292-1295, XP012040542 ISSN: 0034-6748
- ZIOCK H J ET AL: "TESTS OF THE RADIATION HARDNESS OF VLSI INTEGRATED CIRCUITS AND SILICON STRIP DETECTORS FOR THE SSC UNDER NEUTRON, PROTON, AND GAMMA IRRADIATION" IEEE TRANSACTIONS ON NUCLEAR SCIENCE, IEEE SERVICE CENTER, NEW YORK, NY, US, vol. 38, no. 2, 1 avril 1991 (1991-04-01), pages 269-276, XP000229599 ISSN: 0018-9499

## Description

La présente invention concerne un dispositif de test d'un circuit intégré et son procédé de mise en oeuvre. Elle a trait à un dispositif permettant de définir la sensibilité d'un composant électronique à l'ionisation primaire des protons. L'invention a pour but de s'affranchir d'une partie des problèmes liés à la maitrise de l'énergie de protons.

Dans l'état de la technique, on sait que dans les environnements radiatifs naturels spatiaux, atmosphériques, et au niveau du sol, il existe une certaine quantité de protons. Les protons sont des particules qui peuvent interagir avec la matière constitutive des composants électroniques. Cette interaction des protons avec la matière constitutive des composants électroniques peut provoquer des défaillances, appelées événements singuliers si celles-ci sont produites par le passage d'une particule unique.

L'interaction des protons avec la matière constitutive des composants électroniques se fait selon deux mécanismes, dont la dangerosité est fonction du niveau d'énergie de la particule.

On connaît dans l'art antérieur la publication scientifique DUZELLIER S ET AL : « Heavy Ton / Proton Test Results On High Integrated Memories » RADIATION EFFECTS DATA WORKSHOP, 1993, IEEE SNOWBIRD, UT, USA, 21 juillet 1993, NEW YORK, NY, USA, IEEE, 1er janvier 1993, pages 36-42, XP010122967 ISBN : 978-0-7803-1906-6.

On connaît également dans l'art antérieur la publication scientifique SAKAE TAKEJI ET AL : « Conformal irradiation by proton beam scanning and multilayer energy filter » REVIEW OF SCIENTIFIC INSTRUMENTS, AIP, MELVILLE, NY, US, vol. 74, no. 3, 1er mars 2003, pages 1292-1295, XP012040542, ISSN : 0034-6748.

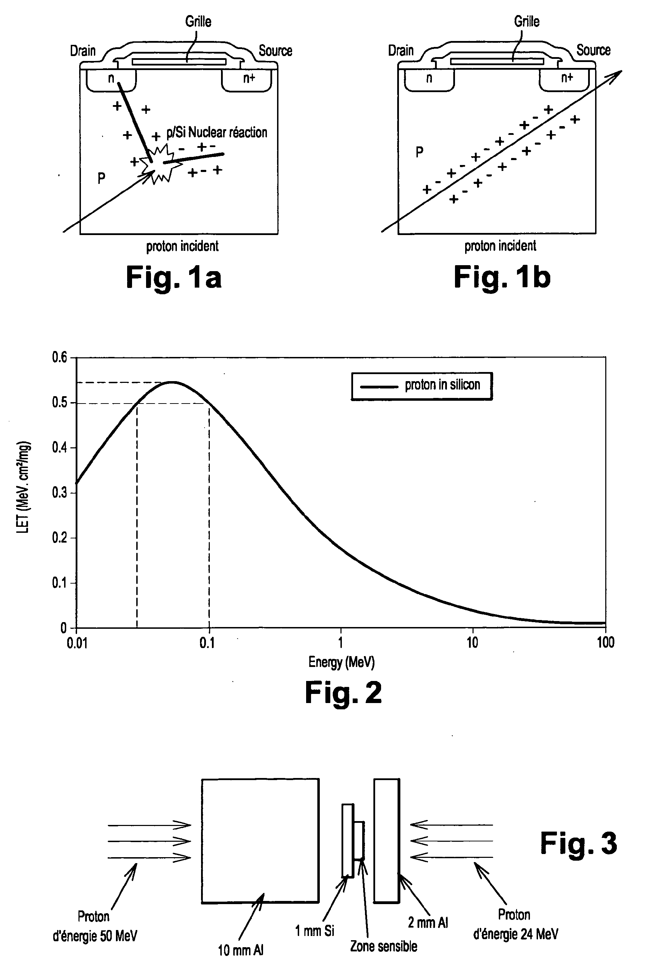

Un premier mécanisme constitue une interaction nucléaire, illustré à la figure 1a. Lors d'une interaction nucléaire, un proton présente une certaine probabilité pour interagir avec un noyau d'un atome cible, provoquant ainsi, une émission de particules secondaires. La probabilité d'interaction entre le noyau et le proton est relativement faible, cependant l'ionisation due à l'émission des particules secondaires peut provoquer des évènements singuliers.

Un deuxième mécanisme illustré à la figure 1b constitue une interaction coulombienne. Dans ce cas, le proton est une particule chargée qui peut par interaction coulombienne provoquer l'ionisation des atomes cibles. Ce mécanisme se produit pour chaque passage d'un proton dans la matière constitutive des composants, cependant, la quantité de charges générées par unité de longueur (pouvoir d'arrêt électronique) est relativement faible et n'atteint son maximum que pour une énergie proche de 0.055 MeV, pour le silicium, comme montré sur la figure 2. Cette position pour laquelle le pouvoir d'arrêt électronique est maximum est appelé par l'homme du métier pic de Bragg. La valeur en énergie du pic de Bragg de l'interaction d'un proton avec la matière varie suivant le matériau semi-conducteur cible. La suite de la description de l'invention utilisera les valeurs en énergie et en pouvoir d'arrêt électronique caractéristique de l'interaction d'un proton avec le silicium, mais l'invention est applicable à tous les autres matériaux semi-conducteur, dans la mesure où le type de courbe tel que présenté figure 2 peut être obtenu par un logiciel connu et disponible : SRIM (www.srim.org).

La figure 2 est donc une courbe représentant le pouvoir d'arrêt électronique d'un proton dans du silicium. Cette courbe traduit la perte d'énergie par unité de longueur par interaction coulombienne d'un proton dans le silicium. On remarque à cet effet, que le maximum de la courbe se situe autour de 0.055 MeV pour un pouvoir d'arrêt électronique correspondant à 0.538 MeV/cm2/mg. Cette courbe montre également que la valeur du pouvoir d'arrêt électronique du proton diminue rapidement lorsque l'énergie du proton augmente.

Jusqu'à des technologies relativement récentes, autrement dit, des gravures avec une résolution supérieure à 130 nm, le seul mécanisme d'interaction d'un proton avec le silicium qui provoque une défaillance, est l'interaction nucléaire. Toutefois, de récentes études, menées en simulation mais également expérimentales, ont démontré que le mécanisme d'ionisation directe des protons pouvait provoquer des évènements singuliers dans les composants les plus intégrés comme le montre les résultats expérimentaux qui ont été obtenus sur une technologie de mémoire SRAM d'IBM 65nm SOI (Silicon On Insulator). La technologie du silicium sur isolant (SOI) fait référence à l'usage de couches de silicium-isolant en lieu et place des classiques substrats de silicium dans la fabrication des semi-conducteurs, afin d'améliorer leurs performances.

L'impact estimé sur les taux de défaillances de ces composants est important, en particulier pour les composants électroniques du domaine spatial où l'environnement protons est important, mais également au niveau atmosphérique. Un autre aspect de cette problématique concerne l'effet du blindage des structures. En effet, les protons perdent une part de leur énergie avant d'interagir avec le composant. Le spectre du proton vu par le composant peut être très différent du spectre nominal. Selon l'épaisseur et le type des matériaux traversés avant d'atteindre la zone sensible du composant électronique, les protons créant des défaillances par ionisation directe peuvent provenir de gammes d'énergies initiales très différentes.

La figure 3 est une représentation schématique de l'influence du parcours d'un proton dans de l'aluminium en fonction de son énergie. Pour un proton qui parcourt 10 mm d'aluminium et 1 mm de silicium, cela induit des interactions de type ionisation directe, potentiellement dangereuses, dans une zone sensible, si le proton a une énergie initiale de 50 MeV. Si le proton a une énergie inférieure, il sera arrêté dans le matériau. Si son énergie est supérieure à 50 MeV, son ionisation directe sera faible. Autrement, un proton qui ne traverse que 2 mm d'aluminium sera considéré comme étant plus dangereux si son énergie est environ de 24 MeV.

Pour pouvoir quantifier le nombre de défaillances attendues pour un environnement de proton donné, il est important de disposer d'un moyen pour caractériser la sensibilité des technologies avancées vis-à-vis de l'ionisation directe des protons. Néanmoins, la caractérisation de la sensibilité des composants électroniques vis à vis de l'ionisation directe des protons est difficile car la gamme d'énergies mise en jeu pour ce phénomène est difficile à mettre en oeuvre expérimentalement.

En effet, pour mettre en évidence le phénomène d'ionisation directe des protons, il faut pouvoir contrôler suffisamment finement l'énergie pour que le proton ait une énergie proche de 0.055 MeV (pour du silicium, la valeur serait différente pour un autre matériau semi-conducteur) lorsqu'il atteint la zone de sensibilité du composant. On entend par zone de sensibilité du composant, une zone dans laquelle des charges déposées sont collectées efficacement et vont contribuer au déclenchement d'une défaillance du composant.

Il est d'autant plus difficile d'étudier ce phénomène d'ionisation directe des protons que les couches de métallisation, le boîtier, les couches d'air entre le composant et la source des protons, provoquent une modification de l'énergie du proton.

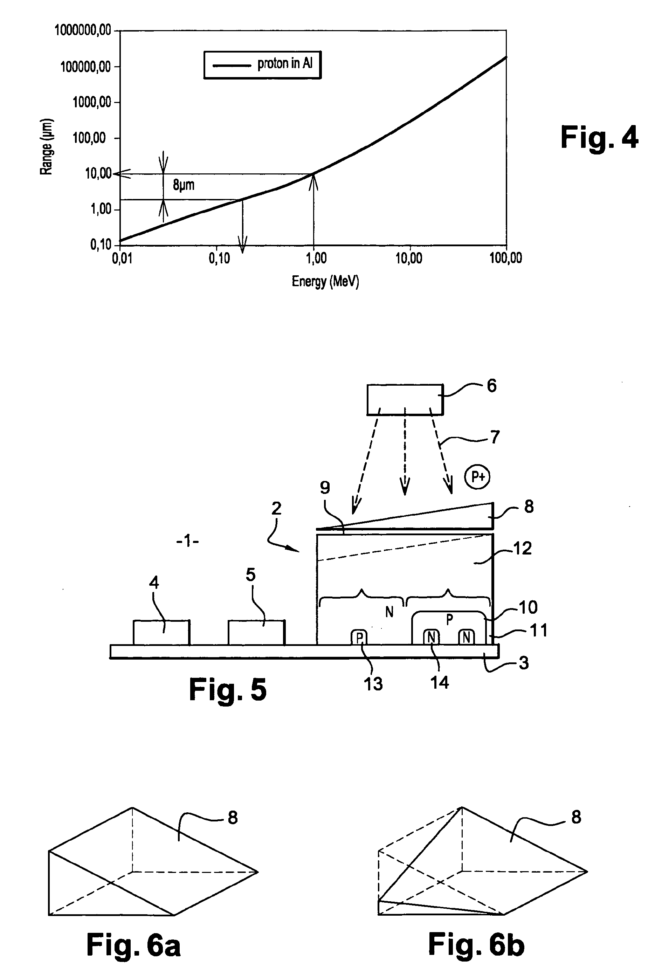

La figure 4 représente une courbe du parcours d'un proton dans une couche d'aluminium en fonction de son énergie. Pour un proton incident de 1 MeV, une couche d'aluminium de 8 µm provoque une diminution d'énergie du proton de 0,8 MeV. Ainsi, sans la connaissance complète des différentes couches, autrement, dit leur composition et leur épaisseur, séparant un faisceau de protons incidents de la zone de sensibilité du composant, il est difficile d'ajuster l'énergie du proton pour maximiser l'ionisation.

L'invention résout ainsi ce problème en proposant un dispositif de test de circuit intégré qui permet d'évaluer la sensibilité d'un composant vis-à-vis de l'ionisation primaire des protons en s'affranchissant des problèmes liés au choix de l'énergie incidente.

Dans l'invention, pour résoudre ce problème, pour être sûr qu'une quantité significative de protons avec une énergie de 0,055 MeV (position en énergie du pic de Bragg pour le silicium) atteigne la zone sensible du composant, on interpose entre ce dernier et un dispositif de bombardement un masque dont l'épaisseur n'est pas uniforme. Dans des endroits où il est plus fin, des protons à basses énergies du rayonnement incident frappent avec effet significatif le composant. Dans des endroits où cette épaisseur est plus forte, seuls des protons à plus haute énergie frappent le composant avec un effet significatif.

Ce masque est soit extérieur au composant électronique, soit constitué par le substrat du composant électronique.

L'invention a donc pour objet, un dispositif de test de circuit intégré, comportant,
- une platine recevant le circuit intégré et comportant des composants permettant son alimentation électrique et la mesure de son fonctionnement pendant le test,
- un dispositif d'irradiation pour soumettre le circuit à un bombardement de protons,
caractérisé en ce qu'il comporte un masque d'épaisseur variable interposé entre une région d'accès du bombardement sur le circuit intégré et une zone implantée du circuit intégré.

L'invention comporte en outre l'une des caractéristiques suivantes :
- le masque est un masque de forme biseauté avec un biseau selon une ou deux dimensions ;
- le masque biseauté comporte localement au moins une épaisseur et ou une nature pour laquelle l'énergie résiduelle d'un proton au niveau de la zone de sensibilité, après avoir traversé cette épaisseur locale, est proche de la position en énergie du pic de Bragg pour l'interaction du proton avec le matériau semi-conducteur du circuit intégré ;
- le masque biseauté comporte en un endroit une épaisseur pour laquelle l'énergie résiduelle d'un proton au niveau de la zone de sensibilité soit supérieure à la position en énergie du pic de Bragg pour l'interaction du proton avec le matériau semi-conducteur du circuit intégré et en autre endroit une épaisseur pour laquelle l'énergie d'un proton incident est totalement absorbée ;

- le masque est formé à partir d'une pièce à rapporter sur le circuit intégré, ou dans un corps du substrat du circuit intégré lui-même ;
- le circuit intégré est posé sur la platine par une face avant correspondant à la zone implantée, et avec une face arrière correspondant au substrat, opposée à la zone implantée, en regard du bombardement ;
- le dispositif d'irradiation comporte un accélérateur de protons.

Elle concerne également un procédé de test d'un circuit intégré comportant les opérations suivantes :
- on place le circuit intégré à tester sur une platine de test de manière à l'alimenter électriquement et à le faire fonctionner,
- on soumet le circuit intégré à tester à un bombardement de protons pendant le test,
- on interpose un masque d'épaisseur variable entre une région d'accès du bombardement sur le circuit intégré et une zone implantée du circuit intégré.
- on mesure le fonctionnement du circuit intégré pendant le test.

L'invention comporte en outre l'une quelconque des opérations suivantes :
- on relève une cartographie de zone de sensibilité du circuit intégré à tester à l'aide d'une installation d'injection de fautes localisées,
- cette cartographie produisant une correspondance entre des adresses logiques dans le circuit intégré et des adresses géographiques dans ce circuit intégré,
- on identifie par la mesure du fonctionnement du circuit intégré pendant le test de bombardement, les adresses logiques qui ont fait l'objet d'un dysfonctionnement correspondant à ce bombardement,
- on déduit à l'aide de la cartographie l'emplacement géographique du dysfonctionnement correspondant à ce bombardement,
- on mesure l'épaisseur du masque à l'emplacement géographique du dysfonctionnement correspondant à ce bombardement,
- on en déduit l'épaisseur ayant donné lieu au dysfonctionnement, donc la caractérisation de la sensibilité à l'ionisation directe des protons.

L'invention sera mieux comprise à la lecture de la description qui suit et à l'examen des figures qui l'accompagnent. Celles-ci ne sont présentées qu'à titre illustratif mais nullement limitatif de l'invention. Les figures montrent :
Figure 1a-b : une représentation schématique des mécanismes d'interaction de proton dans du silicium (déjà décrite) ;
Figure 2 : une courbe représentant le pouvoir d'arrêt électronique d'un proton dans du silicium (déjà décrite) ;
Figure 3 : une représentation schématique de l'influence du parcours d'un proton dans de l'aluminium en fonction de son énergie (déjà décrite) ;
Figure 4 : une courbe représentant le parcours d'un proton dans de l'aluminium en fonction de son énergie (déjà décrite) ;
Figure 5 : une représentation schématique du dispositif de test selon l'invention ;
Figure 6a-b : une représentation schématique du type de masque selon l'invention ;
Figure 7 : une représentation schématique des moyens d'amincissement mécanique d'un masque ou d'un substrat selon l'invention ;
Figure 8 : une représentation schématique du masque selon l'invention ;
Figure 9 : une cartographie laser faisant apparaître la correspondance entre position physique et adresse logique pour les bits d'une mémoire SRAM.
Figure 10 : un diagramme fonctionnel du procédé selon l'invention ;

La figure 5 est une représentation schématique du dispositif 1 de test d'un circuit intégré 2 selon l'invention. Ce circuit intégré 2, grossièrement agrandi, est un composant électronique monté sur une platine 3 pour être soumis à un ensemble de tests de fiabilité. Cette platine 3 comporte des circuits 4 pour alimenter et faire fonctionner le circuit intégré 2. La platine 3 comporte en outre des circuits 5 pour mesurer le fonctionnement du circuit intégré 2 pendant le test.

Le dispositif 1 comporte pour effectuer le test d'un dispositif d'irradiation 6 pour soumettre le circuit 2 à un bombardement de protons 7.

Cependant, il est difficile de mettre en évidence le phénomène d'ionisation directe des protons 7 avec le dispositif d'irradiation rayonnant 6. Avec le bombardement de protons 7 effectué sur le circuit 2, il est nécessaire de pouvoir contrôler suffisamment finement l'énergie émise, pour que le proton 7 ait une énergie proche de la position en énergie du pic de Bragg (0.055 MeV pour le silicium) lorsqu'il atteint la zone de sensibilité 11 du composant. En effet, le maximum du pouvoir d'arrêt électronique d'un proton 7 dans du silicium est situé autour de 0.055 MeV.

Pour résoudre ce problème, l'invention se propose de rajouter un masque 8 d'épaisseur variable, interposé entre une région d'accès du bombardement sur le circuit 2 et une zone implantée 10 du circuit 2. Le circuit 2 est posé sur la platine 3 par une face avant correspondant à la zone implantée 10, et avec une face arrière 9 correspondant au substrat 12, opposée à la zone implantée, en regard du bombardement. Cette zone implantée 10 est la zone fonctionnelle du circuit 2, elle est donc une zone sensible.

Pour réaliser les tests, le boîtier du circuit 2 est de préférence ouvert sur sa face arrière 9, c'est-à-dire la face opposée aux zones de sensibilité 11, afin que les protons n'aient à traverser que le substrat et non des couches de métallisation de nature inconnue.

Le circuit 2 peut comporter, à l'intérieur d'un boîtier, un substrat 12 en matériau semi-conducteur, par exemple en silicium de type n ou p, dans lequel est implanté un caisson 10 de type n pour les substrats de type p, ou vice versa. Le substrat 12 comporte au moins une région de diffusion 13 dans le substrat 12 de type p lorsque le substrat 12 est de type n et vice versa. Comme le substrat 12, le caisson peut comporter des régions de diffusions 14 de type n ou p en fonction de la nature du caisson. De tels arrangements conduisent à la création de diodes et/ou de transistors et/ou de thyristors très sensibles aux effets d'ionisation et qui définissent les zones de sensibilité 11 du composant vis-à-vis de ces effets.

L'invention est ici illustrée pour des composants en technologie Silicium, mais il est tout à fait envisageable de l'appliquer pour d'autres matériaux semi conducteur SiC, GaN, ...

Dans l'invention, le masque 8 est de forme biseauté avec un biseau selon une ou deux dimensions, comme le montre respectivement les figures 6a et 6b. Le masque est montré ici comme surajouté.

Dans un mode préféré de réalisation de l'invention, le substrat 12 du matériau semi-conducteur est aminci pour former le masque 8. Dans ce cas, le masque résulte de la diminution locale de l'épaisseur du substrat. L'amincissement peut être réalisé mécaniquement. Cet amincissement est effectué de biais, de sorte que sur la surface du circuit 2, l'épaisseur résiduelle du substrat varie. Cet amincissement mécanique ne doit pas être destructeur du circuit 2 pour lui permettre de rester fonctionnel pour la même gamme de tensions, fréquences, températures, qu'avant son amincissement.

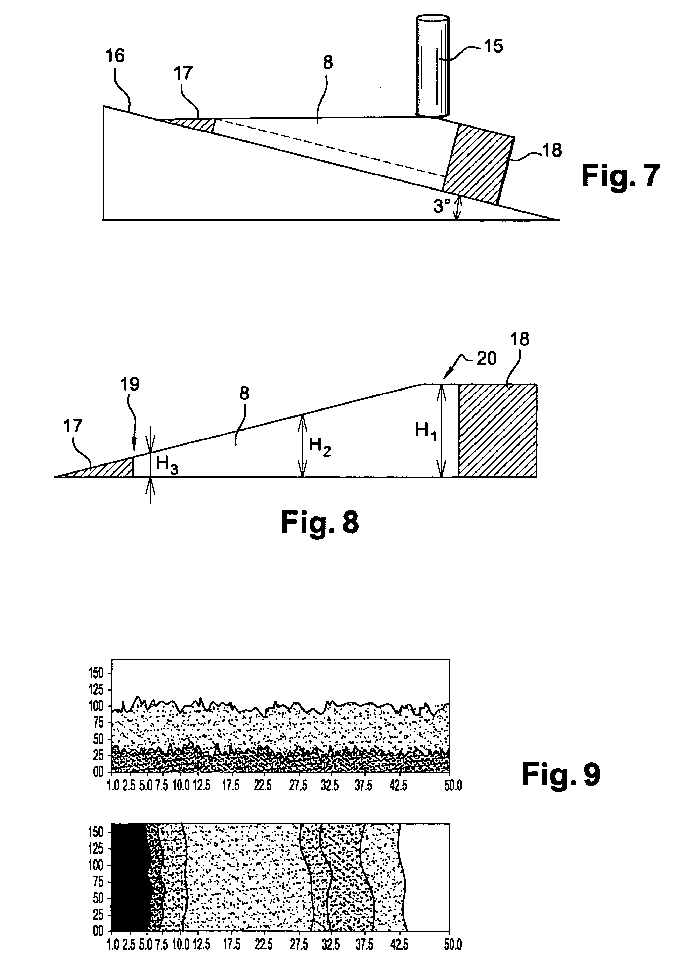

La figure 7 montre que le masque 8 est formé par l'intermédiaire d'un outil 15, par exemple un outil de meulage, dans une pièce à rapporter sur le circuit intégré 2, ou dans un corps du substrat 12 du circuit intégré 2 lui-même. Pour cela, le masque 8 ou le corps du substrat 12 sont maintenus sur une pente 16 par des cales 17, 18 pendant le meulage. La pente 16 du biseau est d'autant plus forte que le circuit intégré 2 à tester est de taille réduite. Le but est d'obtenir une variation d'épaisseur correspondant au spectre énergétique des bombardements protoniques à qualifier. A une énergie E doit correspondre une épaisseur grand M (pour ne laisser passer ou ne produire que des protons dont l'énergie est proche de la position en énergie du pic de Bragg) alors qu'à une énergie plus faible e doit correspondre une épaisseur plus faible m dans le même but. Sur la dimension du composant, l'épaisseur doit passer de M à m.

La figure 8 montre une telle pièce à rapporter sur le circuit 2 testé après amincissement.

Une mesure de l'épaisseur du matériau semi-conducteur est réalisée, en analysant, par exemple, la réflexion pour une longueur d'onde où le matériau semi-conducteur n'absorbe pas ou peu le faisceau laser de la face avant et de la face arrière, en différent point du circuit 2. D'autres méthodes peuvent être également mises en oeuvre, comme la mesure optique de l'épaisseur du composant en observant sa tranche, ou la mesure mécanique.

Lorsque des protons impactent le circuit 2 suite au bombardement, ils traversent, selon les points d'entrée sur la surface du masque ou du substrat biseauté, des épaisseurs de silicium différentes.

Dans un exemple de réalisation de l'invention, si on considère un proton incident avec une énergie de 5 MeV et un masque 8 ou substrat 12, avec une épaisseur résiduelle H3 équivalente à 100 µm sur un bord 19 et une épaisseur H1 égale à 250 µm sur un bord opposé 20, alors le proton 7 incident ne traverse que le silicium jusqu'à la zone de sensibilité 11. Lorsqu'un proton 7 impacte le bord 19, l'énergie résiduelle dans la zone de sensibilité 11 est d'environ 3 MeV. Lorsqu'un proton 7 impacte le bord 20, l'énergie du proton est alors absorbée dans le silicium, avant d'atteindre les zones de sensibilité 11.

Dans la mesure où l'amincissement du silicium est effectué en biseau, le masque ou le substrat biseauté comporte localement au moins une épaisseur et ou une nature (Aluminium, Fer, ...) pour laquelle l'énergie résiduelle d'un proton 7, pour une énergie incidente de 5 MeV, par exemple, après avoir traversé cette épaisseur locale, est proche de la position en énergie du pic de Bragg, soit 0.055 MeV.

Le masque 8 ou le substrat biseauté comporte en un endroit une épaisseur pour laquelle l'énergie résiduelle d'un proton 7 est supérieure à 0.055 MeV et en un autre endroit, une épaisseur pour laquelle l'énergie d'un proton 7 incident est totalement absorbée. C'est-à-dire que le parcours du proton incident doit être compris entre l'épaisseur du bord 19 le plus fin et l'épaisseur du bord 20 le plus épais du substrat.

Le dispositif d'irradiation 6 comporte de préférence un accélérateur de protons 7. Les tests effectués avec le dispositif 6 sur le circuit 2 mettent en évidence, pour certains impacts de protons, des défaillances dues à l'ionisation primaire des protons. Pour d'autres impacts de protons, ce sont des défaillances dues à l'interaction nucléaire proton sur silicium.

Pour différencier ces deux types d'interactions, il est nécessaire de vérifier l'occurrence des évènements. Par exemple, dans le cas d'une zone mémoire, des cellules pour lesquelles l'épaisseur résiduelle de silicium est telle que l'énergie des protons 7 après traversée du silicium se situe dans le domaine préférentiel de l'ionisation primaire, ont une occurrence d'évènements bien plus importante que les autres cellules.

Suite à la traversée du masque, les protons peuvent subir une légère déviation. Ainsi, dans un mode préféré de réalisation de l'invention, le masque est positionné très proche du composant électronique (ce qui est déjà le cas lorsque le masque est constitué du substrat du composant électronique).

Pour valider les résultats du test et estimer l'énergie réelle des protons 7 pour chaque bit identifié en erreur, la correspondance entre les adresses logiques des bits en erreurs, dans une mémoire du composant, et la position physique sur la surface du circuit est nécessaire et peut être déterminée à l'aide d'outil d'injection de fautes, notamment à l'aide d'un laser. Ainsi, une cartographie laser (figure 9) des zones de sensibilité 11 du circuit 2 est préalablement effectuée, elle permet de révéler les zones de sensibilité 11 à une injection de charges de chaque bit du composant. La position physique sur la surface du circuit est identifiée et peut être corrélée à une mesure de l'épaisseur résiduelle de silicium. Il est donc possible, par cette cartographie laser, de remonter pour chaque erreur observée sous un faisceau de protons à l'énergie du proton provoquant la défaillance. Cela permet d'identifier la proportion d'évènements déclenchés par ionisation primaire des protons. Cette méthodologie de correspondance logique/physique et de corrélation avec une épaisseur peut être appliquée à toute structure de cellules logiques régulière comme les mémoires et les FPGA. L'exemple donné sur la figure 9 est appliqué à une mémoire SRAM, mais ne limite en rien l'utilisation de la méthode à d'autres composants.

D'autres méthodes pour déterminer la correspondance logique/physique peuvent être mises en oeuvre, comme notamment l'utilisation de la méthodologie d'injection de fautes à l'aide de particules (ions lourds, protons) soit en utilisant des microfaisceaux, soit en délimitant des zones d'intérêt avec un blindage ou encore l'utilisation d'ondes électromagnétiques pour injecter des fautes ou encore en utilisant directement des données obtenues du fabricant de composants.

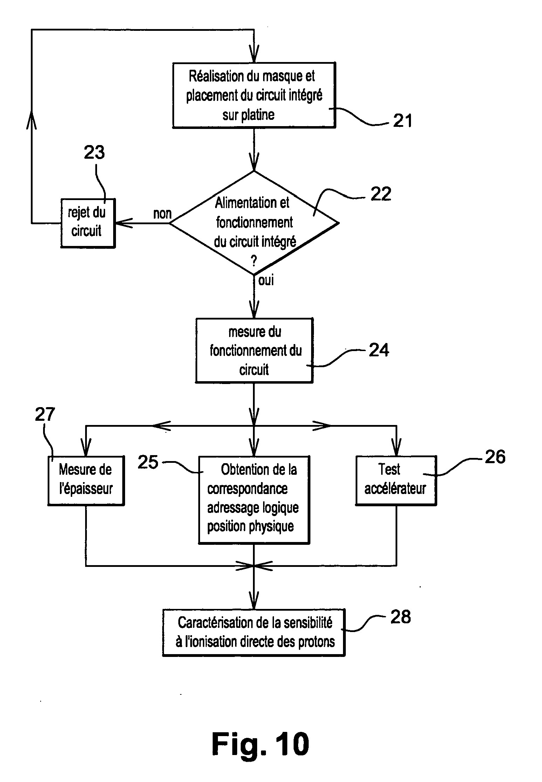

La figure 10 est un exemple d'un diagramme fonctionnel du procédé selon l'invention. Un mode opératoire organise la succession de ces opérations selon le mode suivant. Ce diagramme montre l'opération préliminaire 21 dans laquelle on place le circuit intégré 2 à tester sur une platine 3 de test. Le circuit est placé sur la platine avec un masque 8 ou un substrat 12 ayant préalablement subit un amincissement. Ce masque 8 ou substrat 12 d'épaisseur variable est interposé entre une région d'accès du bombardement sur le circuit intégré 2 et une zone implantée du circuit intégré 2. Lorsque le circuit intégré 2 est placé sur la platine 3, alors on peut effectuer l'opération 22.

Lors de l'opération 22, on alimente et on fait fonctionner le circuit intégré 2 à l'aide de la platine 3 pour diverses tensions d'alimentation et éventuellement températures et fréquences. Lorsque le circuit intégré 2 n'est pas en fonction, alors on peut effectuer l'opération 23, sinon on peut effectuer une opération 24.

Lors de l'opération 23, on rejette le circuit 2 pour dysfonctionnement puis on réitère l'opération 21 avec un nouveau circuit 2.

Lors de l'opération 24, on mesure le fonctionnement du circuit intégré 2 pendant le test.

Lors de l'opération 25, soit le fabricant du composant a fourni les données de correspondance entre la position spatiale des zones de sensibilité 11 et leur position logique, soit on relève à l'aide d'un moyen d'injection de fautes une cartographie de zone de sensibilité 11 du circuit intégré à tester. Le laser peut être un moyen d'injection de faute, mais n'est pas le seul moyen de l'obtenir. Cette cartographie produit une correspondance entre des adresses logiques dans le circuit intégré, par exemple l, c, pour une intersection entre une ligne et une colonne de la mémoire du composant, et des adresses géographiques x, y du lieu à la surface du circuit intégré où a frappé le moyen d'injection de fautes ayant provoqué le dysfonctionnent de cette cellule l, c. Cette correspondance est utilisée ensuite pour savoir où (à l'endroit x, y) les protons ont frappé avec effet sensible le composant (à l'adresse logique l, c). Ce lieu x, y lui même est en relation avec une épaisseur du masque.

Lors de l'opération 26, on soumet le circuit 2 à tester à un bombardement de protons pendant le test. On identifie par la mesure du fonctionnement du circuit intégré pendant le test de bombardement, la partie fonctionnelle de ce circuit intégré qui fait l'objet d'un dysfonctionnement correspondant à ce bombardement, on déduit à l'aide de la cartographie une adresse géographique du lieu géographique du dysfonctionnement correspondant à ce bombardement.

Lors de l'opération 27, on mesure l'épaisseur du masque en différents lieux sur le circuit intégré.

Lorsque les opérations 25, 26, 27 ont été effectuées, alors on peut effectuer l'opération 28.

Lors de l'opération 28, on en déduit l'épaisseur ayant donné lieu au dysfonctionnement, donc la caractérisation de la sensibilité à l'ionisation directe des protons.

## Revendications

1. Dispositif (1) de test de circuit intégré (2) comportant,
- une platine (3) recevant le circuit intégré et comportant des composants (4, 5) permettant son alimentation électrique et la mesure de son fonctionnement pendant le test,
- un dispositif d'irradiation (6) pour soumettre le circuit (2) à un bombardement de protons (7),
**caractérisé en ce qu'**il comporte un masque (8) d'épaisseur variable interposé entre une région d'accès (9) du bombardement sur le circuit intégré (2) et une zone implantée (10) du circuit intégré (2).

2. Dispositif selon la revendication 1, **caractérisé en ce que**
- le masque est un masque de forme biseauté avec un biseau selon une ou deux dimensions.

3. Dispositif selon l'une des revendications 1 à 2, **caractérisé en ce que** le masque biseauté comporte localement au moins une épaisseur et ou une nature pour laquelle l'énergie résiduelle d'un proton au niveau de la zone de sensibilité 11, après avoir traversé cette épaisseur locale, est proche de la position en énergie du pic de Bragg pour l'interaction du proton avec le matériau semi-conducteur du circuit intégré.

4. Dispositif selon la revendication 3, **caractérisé en ce que** le masque biseauté comporte en un endroit une épaisseur pour laquelle l'énergie résiduelle d'un proton au niveau de la zone de sensibilité (11) soit supérieure à la position en énergie du pic de Bragg pour l'interaction du proton avec le matériau semi-conducteur du circuit intégré et en autre endroit une épaisseur pour laquelle l'énergie d'un proton incident est totalement absorbée.

5. Dispositif selon l'une des revendications 1 à 4, **caractérisé en ce que** le masque est formé à partir d'une pièce à rapporter sur le circuit intégré, ou dans un corps du substrat (12) du circuit intégré lui-même.

6. Dispositif selon l'une des revendications 1 à 5, **caractérisé en ce que**,
- le circuit intégré est posé sur la platine par une face avant correspondant à la zone implantée (10), et avec une face arrière correspondant au substrat, opposée à la zone implantée, en regard du bombardement.

7. Dispositif selon l'une des revendications 1 à 6, **caractérisé en ce que** le dispositif d'irradiation comporte un accélérateur de protons.

8. Procédé de test d'un circuit intégré comportant les opérations suivantes :
- on place le circuit intégré (2) à tester sur une platine (3) de test de manière à l'alimenter électriquement et à le faire fonctionner,
- on soumet le circuit intégré à tester à un bombardement de protons (7) pendant le test,
- on interpose un masque (8) d'épaisseur variable entre une région d'accès (9) du bombardement sur le circuit intégré et une zone implantée (10) du circuit intégré.
- on mesure le fonctionnement du circuit intégré pendant le test.

9. Procédé selon la revendication 8 dans lequel
- on relève une cartographie de zone de sensibilité (11) du circuit intégré à tester à l'aide d'une installation d'injection de fautes localisées,
- cette cartographie produisant une correspondance entre des adresses logiques dans le circuit intégré et des adresses géographiques dans ce circuit intégré,
- on identifie par la mesure du fonctionnement du circuit intégré pendant le test de bombardement, les adresses logiques qui ont fait l'objet d'un dysfonctionnement correspondant à ce bombardement,
- on déduit à l'aide de la cartographie l'emplacement géographique du dysfonctionnement correspondant à ce bombardement,
- on mesure l'épaisseur du masque à l'emplacement géographique du dysfonctionnement correspondant à ce bombardement,
- on en déduit l'épaisseur ayant donné lieu au dysfonctionnement, donc la caractérisation de la sensibilité à l'ionisation directe des protons.

## Claims

1. - Device (1) for testing an integrated circuit (2), comprising:
- a panel (3) receiving the integrated circuit and comprising components (4, 5), thereby enabling its supply in electricity and measurement of its functioning during the test,
- an irradiation device (6) to subject the circuit (2) to a bombardment of protons (7),
**characterized in that** it comprises a mask (8) of variable thickness interposed between a bombardment access region (9) on the integrated circuit (2) and an established zone (10) of the integrated circuit (2)

2. - Device according to claim 1, **characterized in that**
- the mask is a beveled-shape mask with a bevel on one or two facets.

3. - Device according to one of the claims 1 to 2, **characterized in that** the beveled mask locally comprises at least one thickness and/or one type, for which the residual energy of a proton in the region of the sensitivity zone (11), after having passed through this local thickness, is close to the energy position of the Bragg peak for interaction of the proton with the semi-conductor material of the integrated circuit

4. - Device according to claim 3, **characterized in that** the beveled mask comprises one thickness in a single place, for which the residual energy of a proton in the region of the sensitivity zone (11) exceeds the energy position of the Bragg peak for interaction of the proton with the semi-conductor material of the integrated circuit, and one thickness in another place for which the energy of an incident proton is totally absorbed.

5. - Device according to one of the claims 1 to 4, **characterized in that** the mask is formed using a part to be added onto the integrated circuit or onto a substrate body (12) of the integrated circuit itself.

6. - Device according to one of the claims 1 to 5, **characterized in that**
- the integrated circuit is set on the panel via a front side corresponding to the established zone (10) and with a rear side corresponding to the substrate, placed opposite the established zone, facing the bombardment.

7. - Device according to one of the claims 1 to 6, **characterized in that** the irradiation device comprises a proton accelerator.

8. . A method for testing an integrated circuit, comprising the following operations:
- the integrated circuit (2) to be tested is placed on a test panel (3) in order to connect it to the power supply and make it work,
- the integrated circuit to be tested is subjected to a bombardment of protons (7) during the test,
- a mask (8) of variable thickness is placed between a bombardment access region (9) on the integrated circuit and an established zone (10) of the integrated circuit,
- the functioning of the integrated circuit is measured during the test.

9. - A method according to claim 8 wherein
- a cartography of the sensitive zone (11) of the integrated circuit to be tested is recorded by installing a localized failure injection system,
- this cartography producing a correspondence between logical addresses inside the integrated circuit and geographical addresses inside this integrated circuit,
- the logical addresses sustaining failure due to this bombardment are identified by measuring the functioning of the integrated circuit during the bombardment test,
- the geographic positioning of the failure corresponding to this bombardment is deduced by using cartography,
- the thickness of the mask is deduced at the geographic positioning of the failure corresponding to this bombardment,
- the thickness having produced the failure is deduced and thus the characterization of the sensitivity to the direct ionization of the protons.

## Patentansprüche

1. - Vorrichtung (1) für den Test einer integrierten Schaltung (2) umfassend,
- eine Platte (3) zur Aufnahme der integrierten Schaltung, die außerdem die Elemente (4, 5) für die Stromversorgung und die Funktionsmessung während des Testverfahrens umfasst,
- eine Bestrahlungsvorrichtung (6) für den Beschuss der Schaltung (2) mit Protonen (7),
**dadurch gekennzeichnet, dass** sie eine Maske (8) variabler Stärke aufweist, die zwischen dem Zugangsbereich (9) des Beschusses auf dem integrierten Schaltkreis (2) und einem eingebauten Bereich (10) des integrierten Schaltkreises (2) angeordnet ist.

2. - Vorrichtung nach Anspruch 1, **dadurch gekennzeichnet, dass**
- die Maske eine Maske mit abgeschrägter Form ist, mit einer Abschrägung in einer oder zwei Dimensionen.

3. - Vorrichtung nach einem der Ansprüche 1 bis 2, **dadurch gekennzeichnet, dass** die abgeschrägte Maske lokal mindestens eine Stärke und/oder eine Beschaffenheit aufweist, aufgrund derer die Restenergie eines Protons nach dem Durchdringen dieser lokalen Stärke in Höhe des Empfindlichkeitsbereichs (11) für die Interaktion des Protons mit dem Halbleitermaterial des integrierten Schaltkreises nahe der Energieposition des Bragg-Peak ist.

4. - Vorrichtung nach Anspruch 3, **dadurch gekennzeichnet, dass** die abgeschrägte Maske an einer Stelle eine Stärke aufweist, durch die die Restenergie eines Protons in Höhe des Empfindlichkeitsbereichs (11) für die Interaktion des Protons mit dem Halbleitermaterial des integrierten Schaltkreises höher als die Energieposition des Bragg-Peak ist, und an einer anderen Stelle eine Stärke, durch die die Energie des auftreffenden Protons vollständig absorbiert wird.

5. - Vorrichtung nach einem der Ansprüche 1 bis 4, **dadurch gekennzeichnet, dass** die Maske anhand eines an der integrierten Schaltung anzubringenden Teils geformt wird oder in einem Substratkörper (12) der integrierten Schaltung selbst.

6. - Vorrichtung nach einem der Ansprüche 1 bis 5, **dadurch gekennzeichnet, dass**
- die integrierte Schaltung mit einer dem eingebauten Bereich (10) entsprechenden Vorderseite und einer dem Substrat entsprechenden Rückseite, dem eingebauten Bereich gegenüber, in Richtung des Beschusses orientiert auf der Platte angeordnet ist.

7. - Vorrichtung nach einem der Ansprüche 1 bis 6, **dadurch gekennzeichnet, dass** die Bestrahlungsvorrichtung einen Protonenbeschleuniger umfasst.

8. - Verfahren zum Testen einer integrierten Schaltung mit folgenden Verfahrensschritten:
- Anordnung der zu testenden integrierten Schaltung (2) auf einer Testplatte (3) derart, dass diese mit Strom versorgt wird und funktioniert,
- während des Tests Beschuss der zu testenden integrierten Schaltung mit Protonen (7),
- Einbringen einer Maske (8) variabler Stärke zwischen dem Zugangsbereich (9) des Beschusses auf der integrierten Schaltung und einem eingebauten Bereich (10) der integrierten Schaltung,
- Messung der Funktion der integrierten Schaltung während des Tests.

9. - Verfahren nach Anspruch 8 mit
- Erstellung einer Kartierung des Empfindlichkeitsbereichs (11) der zu testenden integrierten Schaltung mittels einer Vorrichtung zur Injektion lokalisierter Fehler,
- Mittels dieser Kartierung Herstellung eines Zusammenhangs zwischen den logischen Adressen in der integrierten Schaltung und den geografischen Adressen in dieser integrierten Schaltung,
- Mittels der Funktionsmessung der integrierten Schaltung während des Beschusstests Identifizierung der logischen Adressen, bei denen es durch diesen Beschuss zu Funktionsstörungen kam,
- Anhand der Kartierung Ableitung der geografischen Position der Störung infolge dieses Beschusses,
- Messung der Maskenstärke an der geografischen Position der Störung infolge dieses Beschusses
- Ableitung der die Störung verursachenden Stärke und damit Charakterisierung der Empfindlichkeit gegenüber der direkten Ionisation der Protonen.
